Europäisches Patentamt

(19) European Patent Office

Office européen des brevets

(11) Veröffentlichungsnummer: **0 054 657**
**B1**

(12) # EUROPÄISCHE PATENTSCHRIFT

(45) Veröffentlichungstag der Patentschrift:
11.06.86

(51) Int. Cl.⁴: **C 30 B 13/12, C 30 B 29/06**

(21) Anmeldenummer: 81108512.5

(22) Anmeldetag: 19.10.81

(54) Verfahren zum tiegelfreien Zonenschmelzen.

(30) Priorität: 19.12.80 DE 3048114

(43) Veröffentlichungstag der Anmeldung:
30.06.82 Patentblatt 82/26

(45) Bekanntmachung des Hinweises auf die Patenterteilung:
11.06.86 Patentblatt 86/24

(84) Benannte Vertragsstaaten:
AT DE FR GB IT

(56) Entgegenhaltungen:
EP - A - 0 054 656
DE - A - 2 608 965
DE - B - 1 140 547
US - A - 2 957 789

IBM TECHNICAL DISCLOSURE BULLETIN, Band 18, Nr. 2, Juli 1975, Seite 336 New York, U.S.A. V. SHARMA: "Semiconductor silicon substrate for high yield"
IBM TECHNICAL DISCLOSURE BULLETIN, Band 16, Nr. 8, Januar 1974, Seite 2718 New York, U.S.A. T. CISZEK et al.: "Float zone silicon crystals for device application"

(73) Patentinhaber: Siemens Aktiengesellschaft, Berlin und München Wittelsbacherplatz 2, D-8000 München 2 (DE)

(72) Erfinder: Mühlbauer, Alfred, Dr. Prof., Westerfeldweg 38, D-3002 Wedemark 2 (DE)

## Beschreibung

Die vorliegende Erfindung bezieht sich auf ein Verfahren zum tiegelfreien Zonenschmelzen eines an seinen Enden gehalterten Siliciumstabes, bei dem eine den Stab ringförmig umgebende und eine Schmelzzone im Stab erzeugende Induktionsheizspule innerhalb eines ein definiertes Gasgemisch aus Sauerstoff und einem Schutzgas enthaltenden Rezipienten relativ zum Stab in Stabachsenrichtung bewegt wird, wobei der Partialdruck des Sauerstoffs auf einem Wert gehalten wird, der mindestens gleich groß wie der Dampfdruck des Siliciums bei Schmelztemperatur ist.

Ein solches Verfahren ist beispielsweise im US-Patent 2 957 789 beschrieben worden. Der Einbau von Sauerstoff gegebenenfalls in Verbindung mit einem Schutzgas hat hier den Zweck, die Beweglichkeit des Dotierstoffs Lithium im Germanium und Silicium zu verringern. Im "IBM Technical Disclosure Bulletin", Band 18, Nr. 2, Juli 1975, Seite 336 ist beschrieben, daß ein hoher Sauerstoffgehalt in Verbindung mit niedrigen Kohlenstoffverunreinigungen die Widerstandsfähigkeit des Kristalles gegen die Bildung von Versetzungen in nachfolgenden Hochtemperatur-Diffusionsprozessen erhöhen kann.

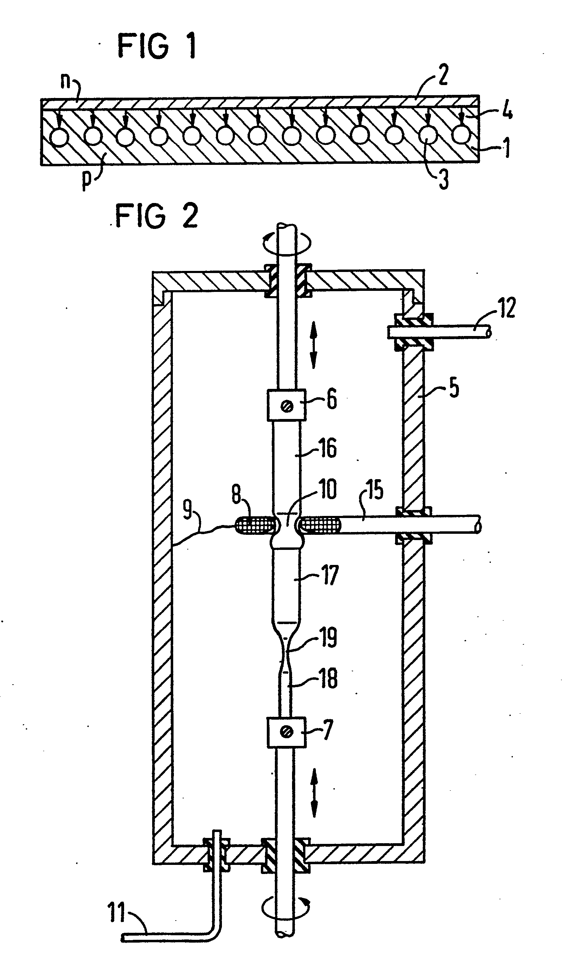

Ausgangspunkt der vorliegenden Erfindung ist die Erkenntnis, daß Sauerstoff im Halbleiter eine getternde Wirkung aufweist. In Fig. 1 ist der Vorgang des Einbaus von Sauerstoff in einen Halbleiterkörper schematisch dargestellt. Das Siliciumplättchen 1 mit seinem oberflächennahen pn-Übergang 2 hat die durch Kreise symbolisch dargestellten Sauerstoffstörstellen 3. Durch die Pfeile 4 sind die Kräfte angedeutet, mit denen der Sauerstoff getternd auf seine Umgebung, insbesondere auf den für die einwandfreie Funktion wichtigen Bereiche der Oberflächenschicht und der angrenzenden Bereiche der Siliciumscheibe einwirkt. Die Sauerstoffstellen wirken als Senken für Verunreinigungen, insbesondere solche von Schwermetallen wie Kupfer, Titan, Wolfram, Gold und Silber, die sich an den Stellen um den Sauerstoff herum ausscheiden. Auch konzentrieren sich Swirls und andere insbesondere komplizierte Gitterstörungen an dieser Stelle.

Es hat sich nun gezeigt, daß die Dotierung mit Sauerstoff beim tiegelfreien Zonenschmelzen im Schmelzzonenbereich Reaktionsprodukte entstehen, die nicht in das Halbleitermaterial eingebaut werden dürfen.

Der Erfindung liegt die Aufgabe zugrunde, ein Verfahren der eingangs erwähnten Gattung so weiterzubilden, daß ein Einbau dieser Reaktionsprodukte vermieden wird.

Diese Aufgabe wird dadurch gelöst, daß das Gasgemisch der Schmelzzone als strömendes Gas zugeführt wird, daß die Geschwindigkeit des Gasgemisches direkt proportional dem im Rezipienten eingestellten Dampfdruck gewählt wird, und daß die Strömungsgeschwindigkeit des Gasgemisches so groß gewählt wird, daß entstehende Reaktionsprodukte aus dem Schmelzzonenbereich wegtransportiert werden.

Vorteilhafterweise wird der Gasstrom durch unterhalb der Schmelzzone liegende Düsen gegen die Schmelzzone geblasen, so daß der Gasstrom zusätzlich mechanisch stabilisierend auf die Schmelzzone einwirkt. Die Geschwindigkeit, mit der der Sauerstoff oder das den Sauerstoff enthaltende Gasgemisch gegen die Schmelzzone geblasen wird, liegt dann zwischen 0,5 und 50 m/s, vorzugsweise zwischen 10 und 50 m/s.

Durch das Verfahren gemäß vorliegender Erfindung ist in technisch einfacher Weise die Herstellung von hochreinem, versetzungsfreiem, einkristallinem Silicium mit einer Sauerstoff-Gesamtkonzentration von etwa $10^{16}$ bis $10^{20}$ Atome pro $cm^3$, vorzugsweise von $10^{18}$ bis $10^{19}$ Atome pro $cm^3$ möglich geworden.

Die Erfindung wird anhand zweier als Ausführungsbeispiele zu wertenden Figuren näher erläutert.

Im einem in Fig. 2 dargestellten, für das tiegelfreie Zonenschmelzen vorgesehehnen Rezipienten 5 befindet sich ein senkrecht stehender, an seinen Enden in Halterung 6 und 7 eingespannter Siliciumstab 16. Eine Heizeinrichtung, die aus einer mit Hochfrequenz gespeisten Induktionsheizspule 8 mit geerdeter Mittelanzapfung 9 besteht und an einem Träger 15 befestigt ist, erzeugt im Siliciumstab eine Schmelzzone 10, die den rekristallisierten Stabteil 17 von dem Stabteil 16 trennt und durch die Relativbewegung der Spule zum Stab längs des Stabes hindurchbewegt wird. Im die Halterung 7 ist ein Keimkristall 18, der beispielsweise im (111)-Richtung orientiert ist, eingespannt; dieser weist zum rekristallisierten Stabteil 17 hin eine flaschenhalsförmige Verengung 19 auf.

Die Ziehgeschwindigkeit wird auf 4 mm/min. und die Rotationsgeschwindigkeit der Halterung 7 des wiedererstarrten Stabteils 17 auf 15 UpM eingsstellt. Durch den Einlaß 11 wird ein Gasgemisch aus Argon und Sauerstoff in das Innere des Reaktors 5 geleitet. Die thermische Konvektion rund um die Schmelzzone in Verbindung mit der gewählten Gasströmung und den eingestellten Partialdrücken von 1,3 bar für Sauerstoff und 0,7 bar für Argon bewirken einen gesteuerten Einbau von Sauerstoff in das zonengezogene Silicium. Entstehende Siliciumoxidverbindungen werden durch den Gasstrom aus der Reaktionszone weggetragen und durch den Gasauslaß 12 abgeführt. Siliciumoxidbelege, erkennbar an auftretenden bräunlichen Schwaden, werden durch Erhöhung der Sauerstoffströmungsgeschwindigkeit mit Sicherheit vermieden.

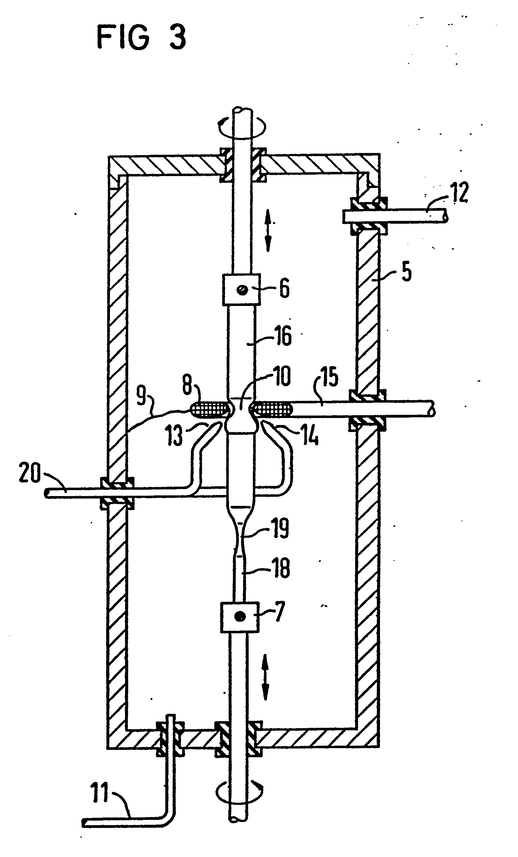

Falls höhere Sauerstoffkonzentrationen im Silicium erwünscht sind, ist das in Fig. 3 dargestellte Verfahren wirkungsvoller. In dem Reaktionsgefäß 5 wird über den Einlaß 11 nur das Schutzgas Argon zugeführt, während über den Einlaß 20 zuströmender reiner Sauerstoff vermöge der Einzeldüsen 13 und 14, die auch zu einer Ringdüse erweitert werden können, sind so unterhalb der Schmelzzone angeordnet, daß die Sauerstoffströmung mechanisch stabilisierend auf die Schmelzzone einwirkt.

Reaktionsprodukte wie Siliciumoxid werden durch die Sauerstoffströmung weggetragen und über den Auslaß 12 abgeführt.

**Patentansprüche**

1. Verfahren zum tiegelfreien Zonenschmelzen eines an seinen Enden gehaltenen Siliciumstabes, bei dem eine den Stab ringförmig umgebende und eine Schmelzzone im Stab erzeugende Induktionsheizspule innerhalb eines ein definiertes Gasgemisch aus Sauerstoff und einem Schutzgas enthaltenden Rezipienten relativ zum Stab in Stabachsenrichtung bewegt wird, wobei der Partialdruck des Sauerstoffs auf einem Wert gehalten wird, der mindestens gleich groß wie der Dampfdruck des Siliciums bei Schmelztemperatur ist, dadurch gekennzeichnet, daß das Gasgemisch der Schmelzzone als strömendes Gas zugeführt wird, daß die Geschwindigkeit des Gasgemisches direkt proportional dem im Rezipienten (5) eingestellten Dampfdruck gewählt wird, und daß die Strömungsgeschwindigkeit des Gasgemisches so groß gewählt wird, daß entstehende Reaktionsprodukte aus dem Schmelzzonenbereich wegtransportiert werden.

2. Verfahren nach Anspruch 1, dadurch gekennzeichnet, daß das Schutzgas dem Rezipienten (5) getrennt über eine eigene Zuleitung (11) zugeführt wird.

3. Verfahren nach Anspruch 1, dadurch gekennzeichnet, daß das Schutzgas dem Sauerstoff vor Einführung in den Rezipienten zugemischt wird.

4. Verfahren nach einem der Ansprüche 1 bis 3, dadurch gekennzeichnet, daß als Schutzgas Argon zugemischt wird. 5. Verfahren nach einem der Ansprüche 1 bis 4, dadurch gekennzeichnet, daß die Reinheit der im Rezipienten verwendeten Gase mindestens der Reinheit des herzustellenden Siliciums entspricht.

6. Verfahren nach Anspruch 2, dadurch gekennzeichnet, daß der Sauerstoff über Düsen (13, 14) gegen die Schmelzzone (10) geblasen wird.

7. Verfahren nach Anspruch 3, dadurch gekennzeichnet, daß das Gasgemisch gegen die Schmelzzone (10) geblasen wird.

8. Verfahren nach wenigstens einem der Ansprüche 1 bis 7, dadurch gekennzeichnet, daß die Strömungsgeschwindigkeit des Sauerstoffs oder des den Sauerstoff enthaltenden Gasgemisches durch eine oder mehrere Einzeldüsen eingestellt wird.

9. Verfahren nach wenigstens einem der Ansprüche 1 bis 8, dadurch gekennzeichnet, daß die Strömungsgeschwindigkeit des Sauerstoffs oder des den Sauerstoff enthaltenden Gasgemisches durch eine Ringdüse eingestellt wird.

10. Verfahren nach wenigstens einem der Ansprüche 1 bis 9, dadurch gekennzeichnet, daß die Düsen so unterhalb der Schmelzzone angeordnet werden, daß ihr Gasstrom mechanisch stabilisierend auf die Schmelzzone einwirkt.

11. Verfahren nach wenigstens einem der Ansprüche 1 bis 10, dadurch gekennzeichnet, daß der Sauerstoff oder das den Sauerstoff enthaltende Gasgemisch mit einer Geschwindigkeit von 0,5 bis 50 m/s, vorzugsweise von 10 bis 50 m/s gegen die Schmelzzone geblasen wird.

12. Verwendung des Verfahrens nach wenigstens einem der Ansprüche 1 bis 11 zur Herstellung von hochreinem, versetzungsarmen, einkristallinem Silicium mit einer Sauerstoff-Gesamtkonzentration von etwa $10^{16}$ bis $10^{20}$ Atome pro $cm^3$, vorzugswese von $10^{18}$ bis $10^{19}$ Atome pro $cm^3$.

**Revendications**

1. Procédé de fusion en zone flottante sans creuset d'une tige de silicium maintenue par une de ses extrémités, dans lequel une bobine de chauffage par induction qui entoure à la manière d'un anneau la tige et y produit une zone en fusion, est déplacée, par rapport à la tige et suivant l'axe de celle-ci, dans un récipient contenant un mélange gazeux déterminé, constitué par de l'oxygène et par un gaz de protection, la pression partielle de l'oxygène étant maintenue à une valeur qui est au moins égale à la pression de vapeur du silicium, à la température de fusion, caractérisé par le fait que le mélange gazeux est amené à la zone en fusion sous la forme d'un courant gazeux, que la vitesse du mélange gazeux est choisie pour être directement proportionnelle à la pression de vapeur réglée dans le récipient (5), et que la vitesse d'écoulement du mélange gazeux est choisie à une valeur élevée telle que les produits résultant de la réaction sont évacués de la région de la zone en fusion.

2. Procédé selon la revendication 1, caractérisé par le fait que le gaz de protection est amené séparément au récipient (5), par l'intermédiaire d'une conduite d'amenée (11).

3. Procédé selon la revendication 1, caractérisé par le fait que le gaz de protection est mélangé à l'oxygène, avant l'introduction dans le récipient.

4. Procédé selon l'une des revendications 1 à 3, caractérisé par le fait que l'on mélange de l'argon comme gaz de protection.

5. Procédé selon l'une des revendications 1 à 4, caractérisé par le fait que la pureté des gaz utilisés dans le récipient correspond au moins à la pureté du silicium à fabriquer.

6. Procédé selon la revendication 2, caractérisé par le fait que l'oxygène est souiflé contre la zone en fusion (10), à l'aide de tuyères (13, 14).

7. Procédé selon la revendication 3, caractérisé par le fait que le mélange gazeux est soufflé contre la zone en fusion (10).

8. Procédé selon au moins l'une des revendications 1 à 7, caractérisé par le fait que la vitesse d'écoulement de l'oxygène ou du mélange gazeux contenant de l'oxygène, est ajustée à l'aide d'une ou de plusieurs tuyères uniques.

9. Procédé selon au moins l'une des revendications 1 à 8, caractérisé par le fait que la vitesse de l'écoulement de l'oxygène ou du mélange gazeux contenant de l'oxygène, est réglée à l'aide d'une tuyère annulaire.

10. Procédé selon au moins l'une des revendications 1 à 9, caractérisé par le fait que les tuyères sont disposées en-dessous de la zone en fusion de façon que leur courant gazeux agisse avec stabilisation mécanique sur la zone en fusion.

11. Procédé selon au moins l'une des revendications 1 à 10, caractérisé par le fait que l'oxygène ou le mélange gazeux contenant l'oxygène est soufflé contre la zone en fusion avec une vitesse de 0,5 à 50 m/s, de préférence avec une vitesse de 10 à 50 m/s. 12. Mise en oeuvre du procédé selon au moins l'une des revendications 1 à 11 pour la fabrication du silicium monocristallin de haute pureté et à faible proportion de dislocations, avec une concentration totale en oxygène d'environ $10^{16}$ à $10^{20}$ atomes par $cm^3$, de préférence avec $10^{18}$ à $10^{19}$ atomes par $cm^3$.

**Claims**

1. Process for the non-crucible zone melting of a silicon rod which is supported at its ends, in which an induction heating coil which surrounds the rod in annular fashion and which produces a molten zone in the rod is moved relative to the rod in the axial direction thereof within a container which contains a predetermined gas mixture consisting of oxygen and a shielding gas, the partial pressure of the oxygen being maintained at a value which is at least equal to the vapour pressure of the silicon at the melting temperature, characterised in that the gas mixture is fed to the molten zone as a flowing gas; that the speed of the gas mixture is selected to be directly proportional to the vapour pressure sent in the container (5); and that the flow rate of the gas mixture is so selected that reaction products produced are carried away from the region of the molten zone.

2. A process as claimed in Claim 1, characterised in that the shielding gas is separately supplied to the container (5) through a separate supply line (11).

3. A process as claimed in Claim 1, characterised in that the shielding gas is added to the oxygen before it is introduced into the container.

4. A process as claimed in one of Claims 1 to 3, characterised in that argon is added as shielding gas.

5. A process as claimed in one of Claims 1 to 4, characterised in that the purity of the gases used in the container corresponds at least to the purity of the silicon to be produced.

6. A process as claimed in Claim 2, characterised in that the oxygen is blown towards the molten zone (10) through nozzles (13, 14).

7. A process as claimed in Claim 3, characterised in that the gas mixture is blown towards the molten zone (10).

8. A process as claimed in at least one of Claims 1 to 7, characterised in that the flow rate of the oxygen, or of the gas mixture which contains the oxygen, is adjusted by means of one or more individual nozzles.

9. A process as claimed in at least one of Claims 1 to 8, characterised in that the flow rate of the oxygen, or of the gas mixture which contains the oxygen, is adjusted by means of an annular nozzle.

10. A process as claimed in at least one of Claims 1 to 9, characterised in that the nozzles are arranged beneath the molten zone in such a way that their gas flow exerts a mechanically stabilising influence on the molten zone. 11. A process as claimed in at least one of Claims 1 to 10, characterised in that the oxygen, or the gas mixture which contains the oxygen, is blown towards the molten zone at a speed of 0.5 to 50 m/s, preferably 10 to 50 m/s.

12. The use of the process as claimed in at least one of Claims 1 to 11 for the production of very pure, low-defect, monocrystalline silicon having an overall oxygen concentration of about $10^{16}$ to $10^{20}$ atoms per $cm^3$, preferably $10^{18}$ to $10^{19}$ atoms per $cm^3$.

# FIG 1

# FIG 2

# FIG 3